# FASCICULE DE BREVET EUROPEEN

(11) **EP 3 492 290 B1**
(45) Date de publication et mention de la délivrance du brevet: **16.02.2022**
(21) Numéro de dépôt: 18209657.8
(22) Date de dépôt: 30.11.2018
(51) Int. Cl.: B60C 23/04, G01R 31/36, G07C 5/00, B60L 8/00, B60L 13/00

(54) **SYSTÈME D ACQUISITION ET D ANALYSE DE DONNÉES ÉMISES PAR DES CAPTEURS EMBARQUÉS DANS DES VÉHICULES, PROCÉDÉ, APPAREIL PORTABLE DE CONTRÔLE ET CONTRÔLEUR EMBARQUÉ ASSOCIÉS**
ERFASSUNGS- UND ANALYSESYSTEM VON DATEN, DIE VON IN FAHRZEUGEN EINGEBAUTEN SENSOREN AUSGESANDT WERDEN, ENTSPRECHENDES VERFAHREN, TRAGBARES KONTROLLGERÄT UND ENTSPRECHENDE EINGEBAUTE KONTROLLEINHEIT
SYSTEM FOR ACQUISITION AND ANALYSIS OF DATA TRANSMITTED BY ON-BOARD SENSORS IN VEHICLES, ASSOCIATED METHOD, PORTABLE CONTROL APPARATUS AND CONTROLLER

(30) Priorité: 30.11.2017 FR 1761462
(43) Date de publication de la demande: 05.06.2019
(73) Titulaire: ATEQ, 78340 Les Clayes sous Bois (FR)
(72) Inventeur: BREBANT, Morgan, 78950 GAMBAIS (FR)
(74) Mandataire: Vidon Brevets & Stratégie

(56) Documents cités:
- WO-A1-2013/063061
- US-A1- 2014 012 459
- US-A1- 2014 225 428

## Description

### 1. Domaine de l'invention

L'invention se rapporte à l'acquisition et l'analyse de données émises par des capteurs placés ou embarqués dans des véhicules. L'invention concerne plus particulièrement le fait que lesdits capteurs fournissent des données relatives à un contrôle et à une surveillance (ci-après également « *monitoring* ») des pneus et de la batterie du véhicule, typiquement par mesure de grandeurs physiques mesurées sur les pneus et sur la batterie du véhicule.

### 2. Etat de la technique

De nos jours, les véhicules disposent de nombreux équipements améliorant la sécurité des passagers. Un élément particulièrement sensible pour la sécurité est les pneus, qui doivent être en bon état afin d'adhérer à la route et permettent un bon contrôle de la trajectoire. La défaillance d'un pneu est généralement due à une fuite du gaz contenu à l'intérieur. Pour éviter l'accident, il est souhaitable de contrôler en permanence la pression de chaque pneu du véhicule.

Des équipements de surveillance de la pression des pneus (appelé « TPMS », acronyme de l'expression Anglo-saxonne « Tyre Pressure Management System ») sont obligatoires dans certains pays, comme les U.S.A.. En Europe, ce système est devenu obligatoire sur tous les véhicules neufs de moins de 3,5 tonnes depuis 2014. Le Japon a déclaré rendre obligatoire cette mesure 1 an après son application en Europe. D'autres pays comme la Russie, l'Indonésie, les Philippines, Israël, la Malaisie et la Turquie entre autres, ont déjà rendu ou vont rendre obligatoire cette mesure. Lorsque la pression du pneu diminue anormalement et que le pneu se déforme, ce qui peut provoquer une explosion, un témoin d'alarme sonore et/ou lumineux apparaît sur le tableau de bord du véhicule pour avertir le conducteur. La détection d'un pneu à plat s'effectue de deux manières, soit de façon directe, soit de façon indirecte.

Les TPMS indirects n'utilisent pas de capteurs de pression physiques, mais mesurent les pressions d'air en surveillant les vitesses individuelles de rotation des roues et d'autres signaux disponibles en dehors du pneu. Les systèmes TPMS de première génération sont basés sur le principe selon lequel les pneus sous-gonflés ont un diamètre légèrement plus petit (et donc une vitesse angulaire plus élevée) que celui d'un système correctement gonflé. Ces différences sont mesurables grâce aux capteurs de vitesse des roues du système d'antiblocage (ou ABS). Etant basé sur le principe d'une différence de comportement d'un pneu à l'autre, ce système ne fonctionne plus si la pression de tous les pneus baisse en même temps. Ce cas peut intervenir si le véhicule roule très lentement sur une route particulièrement froide.

En TPMS direct, un capteur de pneu est installé dans la roue, de préférence au niveau de la tige de soupape du pneu. Ces capteurs mesurent divers paramètres tels que : la pression du gaz, la température des pneus, la vitesse de rotation des roues. Les capteurs eux-mêmes comprennent un code d'identification de capteur spécifique (ID) et sont capables de recevoir des signaux électroniques et d'envoyer des signaux électroniques sans fil vers une unité ou module de contrôle électronique (appelé par la suite « ECU », acronyme de l'expression Anglo-saxonne « Electronic Control Unit ») embarqué dans le véhicule. Si un capteur de roue transmet une pression des pneus ou une autre condition dans un pneu qui est au-dessus ou au-dessous d'un niveau prédéterminé, l'ECU émet des signaux d'alerte vers le tableau de bord à l'intérieur de l'habitacle pour avertir le conducteur.

Un capteur TPMS direct se présente sous la forme d'un module électronique comprenant généralement une pile électrique, une carte de circuit imprimé avec des antennes pour la communication radio bidirectionnelle à courte portée, un capteur de pression d'air, un capteur de température, un dispositif de détection de rotation ou un accéléromètre, un contrôleur programmable et une mémoire pour mémoriser au moins le capteur spécifique ID et d'autres informations en fonction du système TPMS et des capacités. La durée de vie des piles étant limitée, le capteur se place en mode "veille" jusqu'à ce que la roue soit installée sur un véhicule ou vendue à un utilisateur final. Pendant le roulement du véhicule sur le terrain, les capteurs ne sont généralement pas actifs en permanence, ils effectuent des mesures de l'état des pneus à des intervalles prédéterminés pour économiser la durée de vie de la batterie. En activation, les capteurs émettent par radio à courte portée des données vers l'ECU du véhicule à des fins de traitement.

La demande de brevet WO 2013/063061 déposée par la demanderesse et publiée le 2 mai 2013 décrit un système complet de mesure de l'état des pneus montés sur un véhicule. Des opérateurs disposent d'un outil, appelé outil TPMS dans la suite du document. Cet outil est un appareil portable comportant typiquement une batterie, un processeur, une mémoire, une interface utilisateur pour l'affichage d'informations et pour l'entrée de commandes, et un moyen de communication radio. Ce moyen de communication permet notamment la communication avec des capteurs TPMS et éventuellement la communication longue distance avec un serveur via un réseau. L'outil TPMS peut également comporter des ports de communication pour transmettre des données vers un réseau au sol à l'aide d'un câble.

Cet outil est généralement utilisé à la fin d'une chaîne de production ou dans un garage automobile lorsque des pneus sont changés sur une roue, ou lorsque la position des roues d'un véhicule est modifiée. L'opérateur approche l'outil TPMS du pneu concerné afin d'entrer en communication avec le capteur TPMS dont il est équipé. Le TPMS est réveillé et envoie son identifiant, l'opérateur utilise l'outil TPMS pour associer cet identifiant à une position du pneu et transmet l'association au capteur. De cette manière, le capteur mémorise la position du pneu au sein du véhicule et peut la transmettre par la suite. Ensuite, l'outil TPMS communique avec l'ECU du véhicule pour lui transmettre des données provenant des différents capteurs et mettre à jour les informations. Au cours du roulement, l'ECU reçoit régulièrement des données de l'état de chaque pneu et, si ces données sont révélatrices d'une défaillance, l'ECU informe le conducteur du pneu défaillant.

L'outil TPMS peut également comporter un scanner optique destiné à capter des informations visuelles apposées sur un capteur de pneu TPMS, par exemple son étiquette. Généralement, cette étiquette comporte un code à barre qui contient l'identifiant du capteur sous forme numérique. De cette manière, en corrélant l'identifiant fourni par le code à barre avec l'identifiant transmis par radio, l'outil est certain de dialoguer avec le bon capteur. Le scanner peut également être utilisé pour analyser d'autres éléments visuels, par exemple un numéro d'immatriculation du véhicule, ou toute information d'identification concernant le véhicule. A cette fin, l'outil TPMS dispose d'un module de reconnaissance optique de caractères (OCR) permettant de reconnaître les caractères présents sur la plaque d'immatriculation. Ces informations sont affichées sur l'outil TPMS à destination de l'opérateur et/ou transmises à un serveur distant. De cette façon, l'identification du véhicule est facilitée et l'association entre ce véhicule et les interventions effectuées sur ses pneus est plus fiable.

Ce système est performant pour la détection de défaillance d'un pneu ou de plusieurs pneus. De nos jours, les dispositifs de contrôle communiquant avec des capteurs TPMS sont spécialisés dans le seul contrôle des défaillances de pneus, en utilisant uniquement des informations transmises par ces capteurs. Or cette seule information n'est pas nécessairement optimale, voire peut s'avérer insuffisante.

La demande de brevet US 2014/012459 déposée par KRAMER décrit un système embarqué dans un véhicule et destiné à surveiller ce qui s'y passe à l'intérieur, comme par exemple : le comportement du conducteur, la consommation de carburant, les diagnostics du véhicule, la localisation.... L'appareil embarqué entre en communication avec des capteurs dans un véhicule, aucun des capteurs ne concerne les pneus.

La demande de brevet US 2014/255428 déposée par CAMPBELL DOUGLAS décrit un système de surveillance de batterie, embarqué dans un véhicule. Un module intégré à la batterie comporte des capteurs pour mesurer des paramètres tels que la tension, et la température. Ce document n'enseigne ni ne suggère de tester également la pression des pneus ou l'état des capteurs TPMS.

La présente invention décrit une amélioration consistant à prendre en compte et à tester d'autres informations de test ou de contrôle au sein d'un véhicule et/ou à informer le suivi des capteurs en utilisant d'autres types d'informations sur le suivi de l'état du véhicule, et à permettre de réaliser, tant avant livraison des véhicules neufs, que lors des visites ultérieures de maintenance du véhicule, les tests du bon fonctionnement de ces nouveaux traitements de données associés.

### 3. Exposé de l'invention

L'invention a pour but de pallier les inconvénients exposés ci-dessus et à offrir de nouvelles fonctionnalités qui apparaîtront ci-après.

À cet effet, l'invention a pour objet un système de traitement de données émises par des capteurs de pression des pneus montés sur un véhicule, du type comportant un outil de *monitoring* (typiquement un appareil portable ou portatif et/ou un contrôleur embarqué) recevant des données de grandeurs physiques mesurées par des capteurs TPMS sur chaque pneu du véhicule, caractérisé en ce que ledit outil de *monitoring* reçoit également des données relatives à la batterie du véhicule, ledit outil de monitoring comportant en outre des moyens de corrélation de données au sein de l'ensemble formé par lesdites données reçues des capteurs de pression et celles relatives à la batterie ainsi que des données de référence, lesdits moyens de corrélation pilotant des moyens de commande et/ou de mise à jour de fonctions d'alerte et/ou de fonctions de monitoring dudit outil de monitoring.

Typiquement, lesdites données relatives à la batterie du véhicule sont constituées de données de grandeurs physiques relatives à la batterie, mesurées par un capteur de test de ladite batterie, mais selon un autre mode de réalisation complémentaire, elles peuvent également être constituées d'autres types d'information relatifs à la nature et/ou l'état de la batterie.

De cette manière, les mêmes outils de test permettant la surveillance de l'état des roues d'un véhicule sont aussi utilisables pour le contrôle de la batterie, et les informations en provenance de ces deux équipements peuvent être avantageusement combinées pour fournir un système de contrôle et d'alerte amélioré.

En particulier, les procédures de contrôle peuvent obéir à des règles de périodicité et de vigilance qui tiennent compte des informations reçues des deux systèmes de contrôle, et adapter les règles de contrôle et les alertes à la combinaison de ces informations.

En particulier, du fait de l'avènement croissant des véhicules électriques, la prise en compte de l'état réel de la batterie pour effectuer le contrôle des pneus (qui existeront toujours, quel que soit le type de motorisation des véhicules) permet de prendre en compte un élément essentiel de la sécurité du véhicule, et donc d'améliorer - voire de garantir - des opérations de contrôle satisfaisantes.

Partant de là, les appareils portables de test des outils de contrôle embarqué, qu'ils soient utilisés en fin de chaîne de montage pour tester les systèmes embarqués de véhicules neufs, ou lors des opérations de maintenance ultérieure des véhicules au cours de leur vie, sont adaptés pour être en mesure de tester ces différents capteurs et d'exécuter ces différentes procédures.

De plus, le fait de n'utiliser qu'un seul outil de contrôle facilite le travail des opérateurs lors des opérations en fin de chaîne de fabrication ou dans un garage automobile et réduit les coûts et la place occupée par les appareils de contrôle.

Selon une autre caractéristique de l'invention, lesdits moyens de commande et/ou de mise à jour de fonctions de monitoring dudit outil de monitoring appartiennent au groupe comprenant :
- des moyens permettant de mieux identifier un véhicule ;
- des moyens permettant de télécharger et/ou mettre à jour des protocoles des capteurs et/ou des valeurs de références ;
- des moyens de mieux assister l'opérateur, en lui adressant des recommandations et/ou des alertes, notamment en cas d'anomalies simples, d'anomalies combinées, ou de détection d'incompatibilités entre les différents capteurs et/ou avec le véhicule contrôlé.

Selon une autre caractéristique, ledit outil de monitoring est un appareil portable doté d'une interface utilisateur, destiné à coopérer avec un contrôleur embarqué sur ledit véhicule recevant périodiquement des données de grandeurs physiques mesurées par des capteurs TPMS sur chaque pneu du véhicule, et le contrôleur mémorise des données de grandeurs physiques mesurées sur chaque pneu d'une part et sur la batterie du véhicule d'autre part, et les transmet selon un format prédéterminé, sous la forme d'un historique, à l'appareil portable de test.

Dans une variante de l'invention, l'appareil portable dispose d'une caméra destinée à prendre des images des capteurs de pression TPMS et de la batterie afin d'en extraire un ensemble de premières données dont un identifiant dit « premier », l'appareil disposant en outre d'un moyen d'émission d'un signal de réveil vers lesdits capteurs afin de recevoir par radio un ensemble de secondes données dont un identifiant dit « second », l'égalité entre le premier et le second identifiants déclenchant la mémorisation d'une association entre cet identifiant et une information représentative de la position et du type de capteur placé devant l'outil.

Selon une autre caractéristique, l'invention concerne un procédé de test et de contrôle de sécurité d'un véhicule mis en œuvre dans un système de traitement de données tel que décrit dans les paragraphes précédents, ledit procédé comprenant les étapes suivantes :
- mise en communication de l'appareil portable avec le contrôleur embarqué ;
- émission par l'appareil portable vers le contrôleur embarqué d'une requête pour obtenir la transmission d'une première série de données issues tant des capteurs TPMS que du capteur de batterie ;
- en fonction d'un traitement effectué dans l'appareil portable sur ladite première série de données, l'appareil portable communique une seconde fois avec le contrôleur embarqué pour obtenir la transmission d'une deuxième série de données issues des capteurs TPMS et/ou du capteur de batterie.

Selon un troisième aspect, l'invention concerne un procédé de test et de contrôle de sécurité d'un véhicule mis en œuvre dans un système de traitement de données tel que décrit ci-dessus. Ce procédé comprend les étapes suivantes :
- mise en communication de l'appareil portable de test avec le contrôleur embarqué ;
- vérification que le moteur du véhicule est à l'arrêt ou en marche suivant la procédure de test à réaliser ;
- simulation du roulement du véhicule roule sur un banc de test approprié ;
- pilotage par l'appareil portable de test du contrôleur embarqué pour exécuter au moins une phase de test prédéterminée selon un protocole de test du bon fonctionnement du système de traitement de données ;
- récupération par l'appareil portable en provenance du contrôleur embarqué d'au moins une première série de données issues tant des capteurs TPMS que du capteur de batterie telles que générées pendant ladite phase de test prédéterminée.

Selon un quatrième aspect, l'invention concerne un procédé de test et de contrôle de sécurité d'un véhicule mis en œuvre dans un système de traitement de données tel que décrit ci-dessus et appliqué à un véhicule dans lequel un système de charge de batterie est connecté et déconnecté en fonction de premières données relatives à l'état de charge de ladite batterie. Le système de charge de batterie est également piloté à partir de secondes données fournies par le contrôleur embarqué, et relatives aux données de grandeurs physiques mesurées sur chaque pneu du véhicule.

### 4. Liste des figures

D'autres caractéristiques et avantages de l'invention ressortiront de la description ci-après, fournie à titre d'exemple non limitatif, et faite en référence aux dessins annexés, dans lesquels :
- la figure 1 présente un appareil portable de test destiné à récupérer des données provenant de capteurs de pression des pneus d'un véhicule, selon l'art antérieur ;
- la figure 2 présente un véhicule doté d'un système de surveillance et de monitoring des pneus et de la batterie selon un exemple préféré de réalisation ;
- la figure 3 présente un organigramme des opérations d'acquisition et d'analyse des données émises par des capteurs montés ou embarqués dans des véhicules, à l'aide d'un système selon l'invention.

### 5. Description détaillée de l'invention

Les éléments identiques sur les différentes figures, portent les mêmes références.

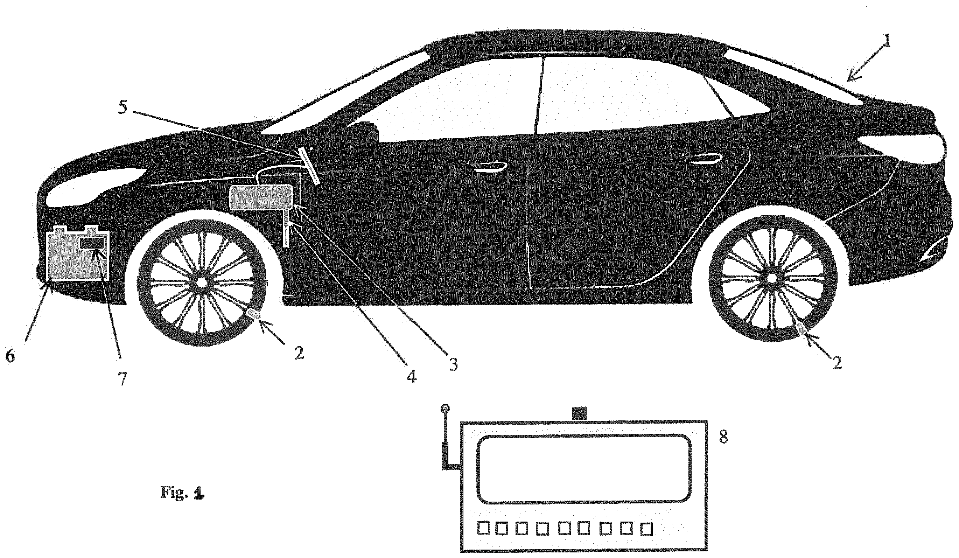

La **Fig. 1** représente un véhicule 1 doté de pneus comportant des capteurs TPMS actifs 2. Ce véhicule peut être une voiture de tourisme, un fourgon, un camion, un tracteur et de façon plus générale, tout véhicule se déplaçant sur des roues avec des pneus gonflés d'un gaz. Ce véhicule peut être à propulsion thermique ou électrique. Les capteurs associés à chaque roue comportent typiquement un module électronique comprenant une pile électrique, une carte de circuit imprimé avec des antennes ou des bobines de communication (pour la réception et la transmission), un capteur de pression d'air, un capteur de température, un dispositif de détection de rotation ou un accéléromètre, un contrôleur programmable et une mémoire pour mémoriser des données telles que l'identifiant ID du capteur ID. Compte tenu du mode d'encapsulation, il n'est généralement pas prévu de changer la pile. Les capteurs transmettent régulièrement leurs informations vers une ECU 3 par une liaison sans fil à courte portée, l'ECU étant dotée d'une antenne 4. L'ECU communique également avec le tableau de bord 5 pour transmettre des signaux représentatifs de l'état de certains équipements du véhicule et éventuellement un signal d'alarme.

Le véhicule comporte au moins une batterie 6 qui peut être la source d'énergie du roulement dans le cas d'un véhicule électrique, ou être chargée par un alternateur dans le cas d'un véhicule équipé d'un moteur thermique. Ladite batterie est dotée d'un module de contrôle 7 comprenant un microcontrôleur relié à des antennes ou des bobines de communication pour la réception et la transmission de données par une liaison sans fil à courte portée. Le module de contrôle comporte en outre un convertisseur A/D pour mesurer la tension de la batterie, un capteur de température et une mémoire pour mémoriser des données telles que l'identifiant ID du module. Le module de contrôle 7 transmet régulièrement des signaux vers l'ECU 3 afin de lui communiquer la tension et la température de la batterie 6. Selon un perfectionnement, le module possède un moyen de mesure de l'intensité du courant délivré par la batterie. Ce moyen de mesure peut être un voltmètre mesurant la tension aux bornes d'un shunt de très faible résistance, ou un capteur à effet Hall captant le champ magnétique généré par le passage du courant sur un câble de sortie de la batterie. Selon une variante de réalisation, le véhicule peut être doté de plusieurs batteries (ce qui est généralement le cas pour un véhicule électrique, chaque batterie comporte son propre module de contrôle 7.

Un système d'acquisition et d'analyse de données émises par des capteurs embarqués dans des véhicules comporte un outil 8 dit « outil TPMS » destiné notamment à recevoir et traiter des données provenant de capteurs TPMS actifs. Cet outil visible sur la **Fig. 1** est un appareil portable de test comportant typiquement une batterie, un processeur, une mémoire, une interface utilisateur pour l'affichage d'informations et pour l'entrée de commandes, et un moyen de communication radio. Ce moyen de communication comporte notamment une antenne émettrice d'un champ électromagnétique qui permet notamment la communication avec des capteurs TPMS et éventuellement la communication longue distance avec un serveur via un réseau.

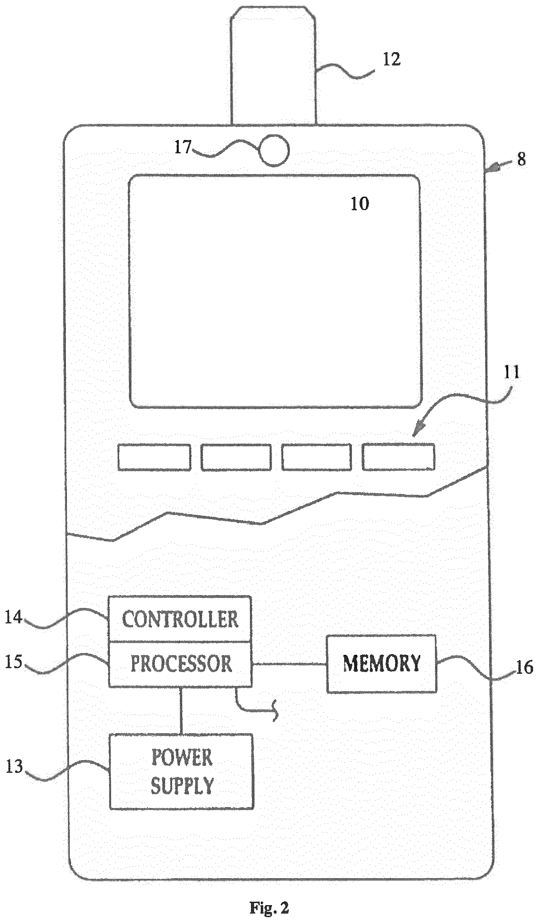

Un exemple de réalisation d'un outil TPMS est maintenant décrit à l'aide de la **Fig. 2****.** L'outil TPMS 8 est un appareil portable de test comprenant un boîtier ayant une interface utilisateur en face avant qui comprend un panneau d'affichage 10 à cristaux liquides (LCD) de référence, plusieurs voyants lumineux 11, un clavier à bouton-poussoir (non visible sur la figure, situé en dessous de l'écran 10) et une antenne 12. L'antenne 12 est conçue pour communiquer avec le module de contrôle électronique ECU 3 et de façon sans fil avec des capteurs TPMS 2 installés dans les roues du véhicule 1. Dans l'exemple illustré par la **Fig. 2**, l'antenne 12 est une antenne basse fréquence, mais d'autres antennes pour transmettre et recevoir d'autres fréquences peuvent être utilisées. L'outil TPMS 8 comporte également une alimentation électrique autonome 13 telle qu'une batterie rechargeable, un contrôleur 14 et un microprocesseur 15 exécutant un module logiciel stocké dans une mémoire 16. La mémoire est du type non-volatile afin de sauvegarder des données et éventuellement des historiques des différentes mesures effectuées. Selon une variante de réalisation, l'outil TPMS comporte également au moins un connecteur placé sur le côté de l'appareil pour communiquer via un câble avec l'ECU 3 embarqué dans le véhicule, ou tout autre appareil et notamment le réseau informatique de la chaîne de fabrication et d'un garage automobile.

Selon un mode de réalisation avantageux, l'outil TPMS dispose d'un scanner optique ou d'une caméra 17 destiné à capter des informations visuelles présentes sur un équipement du véhicule. Suite à l'introduction d'une commande de l'opérateur, l'outil capte une image de l'autocollant présent sur le capteur TPMS, ou de l'étiquette présente sur la batterie. Ces inscriptions comportent un code à barre qui contient l'identifiant du capteur sous forme numérique. Le module logiciel comporte un OCR permettant d'analyser l'image captée et d'en d'extraire les caractères. De cette façon, l'outil TPMS peut déterminer de façon optique des caractéristiques des différents capteurs et de la batterie et notamment de connaître leurs identifiants. Le scanner 17 peut également être utilisé pour déterminer d'autres caractéristiques, par exemple le numéro d'immatriculation du véhicule, ou toute information d'identification concernant ce véhicule.

Selon un autre mode de réalisation possible, l'outil TPMS dispose d'un moyen de communication radio (en utilisant par exemple le Wifi) avec un serveur distant, afin de lui transmettre des informations relatives à un véhicule. Ce dispositif peut être utilisé en fin de chaîne de fabrication pour indiquer que les pneus et la batterie ont été installés et pour transmettre les données provenant des capteurs.

Après avoir détaillé des exemples des principaux éléments constitutifs de l'invention, nous allons maintenant décrire comment ceux-ci coopèrent.

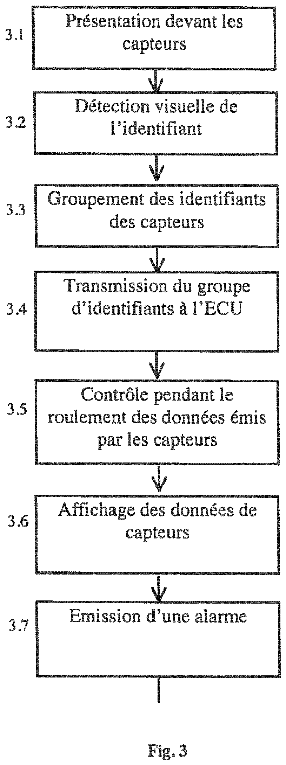

La **Fig. 3** présente un exemple d'organigramme des opérations d'acquisition et d'analyse des données émises par des capteurs montés ou embarqués dans des véhicules, selon l'invention.

Il est à noter que l'invention met en œuvre des opérations de corrélation et de traitement desdites données au moyen d'un outil de monitoring qui peut être soit une unité embarquée, typiquement un contrôleur embarqué, soit une unité utilisée par un opérateur chargé de la maintenance ou de la réparation, typiquement un appareil portable de contrôle. Ces opérations peuvent aussi être réparties entre ces deux types d'unités.

Les moyens de corrélation des données reçues par l'outil de monitoring consistent à comparer tout ou partie desdites données reçues des capteurs de pression et de celles relatives à la batterie avec des valeurs de référence. Les résultats de ces corrélations servent à piloter des moyens de commande et/ou de mise à jour de fonctions d'alerte et/ou de monitoring dudit outil de monitoring, comme illustré par quelques exemples ci-après.

Supposons par exemple qu'à un certain moment de nouveaux capteurs soient installés ou que ces capteurs changent de place. Prenons par exemple le cas d'une fin de chaîne de fabrication d'un véhicule où les opérateurs ont assemblé tous les éléments, mis une batterie et installés tous les pneus. A ce moment, l'ECU 3 doit être configuré pour permettre l'acquisition par radio des données émises par les capteurs 2 et du module de contrôle de la batterie 7. Un autre exemple est celui d'un garagiste qui constate que les pneus avant sont plus usés que les pneus à l'arrière du véhicule ; à la demande du propriétaire, le garagiste échange les pneus à l'avant et les pneus à l'arrière. L'ECU 3 doit être informé de cette modification.

Lors d'une première étape 3.1, un opérateur utilise son outil TPMS 8 et le présente successivement devant les capteurs 2 et le module de contrôle de la batterie 7. L'opérateur introduit sur le clavier de l'outil TPMS le type de capteur (capteur de pneu, capteur de batterie, ...) et éventuellement à leurs positions (pneu avant droit, pneu avant gauche, pneu de secours, ...) qui est devant l'outil. En appuyant sur une touche, l'outil TPMS 8 émet un signal de réveil vers ce capteur et celui-ci répond en transmettant ses données, dont son identifiant. Selon un perfectionnement, l'opérateur utilise le scanner 17 de l'outil TPMS pour capter les caractères apposés sur le capteur TPMS ou sur la batterie qui est devant l'outil. L'ECU récupère alors un identifiant graphique du capteur TPMS ou du module de contrôle 7 et le corrèle avec l'identifiant transmis par la liaison radio (étape 3.2). Si les identifiants sont identiques alors l'ECU enregistre les données en les associant avec la position et le type du capteur introduits précédemment par l'opérateur.

A la fin de cette étape, l'outil TPMS a récolté toutes les données provenant des capteurs du véhicule en les associant à leurs types et éventuellement à leurs positions. L'outil rassemble ces données en un paquet (étape 3.3) en associant chaque identifiant de capteur avec son type et sa position. Ce paquet se présente sous la forme d'un tableau dont un exemple est présenté ci-après :

| Identifiant | Type | Position |
|---|---|---|
| A4B7B9B3B6 | Capteur TPMS | Avant - Gauche |
| 9B6DC950AE | Capteur TPMS | Avant - Gauche |
| 4794C4D2AB6 | Capteur TPMS | Avant - Gauche |
| 897987DE3AB | Capteur TPMS | Avant - Gauche |
| 765DF43ABE8 | Capteur Batterie | Batterie principale |

A l'étape 3.4, l'outil TPMS transmet par radio et par le câble ce paquet de données à l'ECU 3. A partir de ce moment, l'ECU 3 est capable de recevoir des données provenant de ces capteurs et de déterminer à quoi ces données correspondent.

Au cours du roulement du véhicule (étape 3.5), les capteurs 2 et le module 7 transmettent régulièrement leurs données à l'ECU 3 qui contrôlent alors si ces données correspondent à un fonctionnement normal. Au cours de cette étape, l'ECU communique avec le tableau de bord 5 pour transmettre des signaux représentatifs de l'état de certains équipements du véhicule, notamment la tension de la batterie, et éventuellement la pression des pneus. Si les mesures effectuées par les capteurs s'écartent d'une fourchette de valeurs admissibles (valeurs « de référence »), l'ECU émet un signal d'alarme vers le tableau de bord 5 (étape 3.6) afin d'en avertir le conducteur.

Dans une variante d'utilisation de l'invention, dans laquelle la fiabilité de l'information fournie par les capteurs TPMS, ou leur traitement ultérieur, dépend d'un paramètre lié à la batterie, comme la nature, ou la tension de la batterie, on peut prévoir que le signal reçu de la batterie permet de détecter ou d'anticiper que l'information reçues des capteurs TMPS n'est pas fiable, ou va perdre sa fiabilité. Dans un tel cas, l'ECU va émettre un signal d'alerte approprié, par exemple vers le tableau de bord du véhicule. Cette modalité d'utilisation suppose que la chaîne de contrôle de la batterie soit moins sensible à la tension de la batterie que celle des capteurs TPMS, ou autrement dit que la mesure et/ou l'interprétation du paramètre de batterie soit systématiquement plus fiable que celles des capteurs TPMS.

Selon une autre caractéristique de l'invention, l'ECU analyse les variations des données fournies par les capteurs TPMS 2 afin de déterminer si le véhicule 1 roule. Si c'est le cas, et si le véhicule possède un moteur thermique, alors la batterie devrait être en charge et présenter une tension élevée. Si l'ECU détecte que depuis un certain temps la tension décroit, alors l'alternateur ne charge pas la batterie. L'ECU émet alors un signal vers le tableau de bord et éventuellement par radio un signal informant de cet état.

Selon une autre caractéristique de l'invention, l'ECU 3 analyse les variations des données fournies par les capteurs TPMS 2 afin de déterminer si le véhicule 1 roule. Si c'est le cas, et si le véhicule possède un moteur thermique, alors la batterie devrait être en charge et présenter une tension élevée. Si l'ECU détecte que depuis un certain temps la tension décroit, alors l'alternateur ne charge pas la batterie. L'ECU émet alors un signal vers le tableau de bord et éventuellement par radio un signal informant de cet état.

Selon une autre caractéristique, l'ECU 3 analyse les variations des données fournies par les capteurs TPMS 2 afin de déduire que le véhicule est arrêté, un tel état se caractérise par une absence de variation de la pression de chacun des quatre pneus. Le véhicule étant arrêté, lorsque l'ECU détecte une diminution de la tension de la batterie qui atteint une valeur en dessous d'un certain seuil alors l'ECU déclenche une alarme sonore ou visuelle perceptible par le conducteur. Cet état signifie que des dispositifs électriques sont restés alimentés dans le véhicule après son arrêt, ce qui risque de mettre la batterie à plat.

Les batteries proviennent de nombreux constructeurs et les modules de contrôle 7 insérés à l'intérieur n'ont pas le même protocole de communication. Dans certains cas, l'ECU 3 n'est pas capable d'emblée de recevoir les signaux. Pour pallier cet inconvénient et selon un autre mode de mise en œuvre de l'invention, au cours de l'étape 3.2, le module de contrôle 7 de la batterie émet une information sur son protocole de communication. Ce protocole peut comporter par exemple un certain format de données émises à des intervalles de temps déterminés. L'outil TPMS reçoit l'information sur le protocole de communication et si besoin, communique avec un serveur distant afin d'acquérir ce protocole. Une fois que toutes les informations permettant à l'ECU 3 de recevoir les données provenant du serveur sont dans la mémoire 16 de l'outil TPMS, ce dernier les transmet à l'ECU 3. De cette façon, l'ECU est capable de recevoir et d'analyser les données émises par n'importe quel type de capteur.

Selon un autre mode de mise en œuvre de l'invention, à l'étape 3.2 l'opérateur commande à son outil TPMS 8 de scanner l'étiquette de la batterie. Les informations lues permettent alors de déterminer ses caractéristiques en termes de tension et de capacité électriques. L'outil TPMS dispose également des caractéristiques du véhicule transmises par le constructeur. De ce fait, l'outil est capable de détecter si la batterie installée est bien conforme aux spécifications du constructeur. Ce type de vérification est également possible au niveau des pneus. Connaissant le type du véhicule, l'outil TPMS est capable de détecter si les caractéristiques du pneu (diamètre, largeur, ...) correspondent bien aux préconisations du constructeur et sur la pression des pneus se situe dans la fourchette de valeurs recommandées. Si l'outil TPMS détecte une anomalie, il affiche sur l'écran à la fois ce qui est détecté et ce qui est préconisé par le constructeur.

Selon un autre mode de mise en œuvre de l'invention, le véhicule dispose d'un système d'alternateur de charge intelligent, par exemple du type fournissant à la batterie la quantité d'électricité dont elle a besoin, et stoppant la charge lorsque celle-ci vérifie certains critères par lesquels il est considéré qu'elle est suffisamment chargée. Selon un mode de réalisation possible connu, l'ECU traite continûment les informations transmises par le module de contrôle 7 et calcule la quantité d'électricité débitée par la batterie. L'ECU commande alors l'alternateur pour fournir à la batterie exactement la même quantité d'électricité. Lorsque la batterie est de nouveau à 100%, alors l'ECU déconnecte l'alternateur qui tourne alors sans générer de courant. Selon une des logiques de pilotage de ce type d'alternateur « intelligent », l'absence de courant dans les bobinages ne génère plus de forces électromagnétiques, soulageant ainsi le moteur thermique du véhicule et améliorant son rendement. D'autres logiques de pilotage existent ou sont envisageables.

Selon un mode de réalisation de l'invention, le procédé de commande de la connexion et déconnexion de l'alternateur de la batterie va aussi tenir compte de l'information en provenance des capteurs TPMS du véhicule pour ajouter un facteur d'optimisation dans le pilotage de la charge de la batterie. Ainsi, par exemple, en cas de détection d'un risque de défaillance d'un pneu, le système va favoriser ou non la recharge de la batterie au détriment des autres facteurs conditionnant la connexion ou la déconnexion de l'alternateur.

Plus généralement, la prise en compte combinée des signaux de contrôle des pneus et de la batterie permet de mieux détecter et gérer les situations d'insécurité multiple ou de cumul de défaillances. Ces situations sont rares, mais la performance d'un système de sécurité, et des procédures de contrôle de son intégrité et de son bon fonctionnement, suppose de prendre en compte ces situations particulièrement problématiques de cumuls de défaillances.

Les appareils portatifs de contrôle selon l'invention, selon une variante de réalisation, permettent donc de tester et valider le bon fonctionnement de ces procédures de gestion de priorité d'alerte et de pilotage, et l'impact correct d'une détection de défaillance de pneu(s) par le système TPMS sur le pilotage de l'« alternateur intelligent ».

Bien que la présente invention ait été décrite en référence aux modes de réalisation particuliers illustrés, celle-ci n'est nullement limitée par ces modes de réalisation, mais ne l'est que par les revendications annexées. En particulier, la présente invention peut être utilisée par tout type de véhicule doté de roues gonflées par un gaz. On notera que des changements ou des modifications pourront être apportés par l'Homme du métier.

## Revendications

1. Système de traitement de données émises par des capteurs de pression (2) des pneus montés sur un véhicule (1), du type comportant un outil de monitoring recevant des données de grandeurs physiques mesurées par des capteurs TPMS sur chaque pneu du véhicule,
**caractérisé en ce que** ledit outil de monitoring reçoit également des données relatives à la batterie (6) du véhicule,
ledit outil de monitoring comportant en outre des moyens de corrélation de données au sein de l'ensemble formé par lesdites données reçues des capteurs de pression et celles relatives à la batterie ainsi que des valeurs de référence, lesdits moyens de corrélation pilotant des moyens de commande et/ou de mise à jour de fonctions d'alerte et/ou de monitoring dudit outil de monitoring.

2. Système de traitement de données selon la revendication 1, **caractérisé en ce que** ledit outil de monitoring appartient au groupe comprenant un appareil portable de test (8) doté d'une interface utilisateur, et un contrôleur embarqué (3) sur ledit véhicule.

3. Système de traitement de données selon l'une quelconque des revendications 1 et 2, **caractérisé en ce que** lesdites données relatives à la batterie (6) du véhicule, sont constituées de données de grandeurs physiques relatives à la batterie, mesurées par un capteur (7) de test de ladite batterie.

4. Système de traitement de données selon l'une quelconque des revendications 1 à 3, **caractérisé en ce que** lesdits moyens de commande et/ou de mise à jour de fonctions de monitoring dudit outil de monitoring appartiennent au groupe comprenant:
- des moyens permettant de mieux identifier un véhicule ;
- des moyens permettant de télécharger et/ou mettre à jour des protocoles d'interrogation des capteurs et/ou des valeurs de références ;
- des moyens de mieux assister l'opérateur, en lui adressant des recommandations et/ou des alertes.

5. Système de traitement de données selon l'une quelconque des revendications 1 à 4, **caractérisé en ce que** ledit outil de monitoring est un appareil portable (8) doté d'une interface utilisateur, destiné à coopérer avec un contrôleur embarqué (3) sur ledit véhicule recevant périodiquement des données de grandeurs physiques mesurées par des capteurs TPMS sur chaque pneu du véhicule,
et **en ce que** le contrôleur (3) mémorise des données de grandeurs physiques mesurées sur chaque pneu d'une part et sur la batterie du véhicule d'autre part, et les transmet selon un format prédéterminé sous la forme d'un historique à l'appareil portable de test.

6. Système de traitement de données selon la revendication 1, dans lequel ledit outil de monitoring un contrôleur embarqué (3) sur ledit véhicule recevant périodiquement des données de grandeurs physiques mesurées par des capteurs TPMS sur chaque pneu du véhicule,
et dans lequel le véhicule (1) possède un moteur thermique et un alternateur rechargeant la batterie lorsque le véhicule roule,
**caractérisé en ce que** le contrôleur embarqué (3) possède des moyens de déduire que le véhicule roule par analyse des variations relatives de la pression de tout ou partie des quatre pneus, et **en ce qu'**il comprend des moyens de déclenchement d'une alarme sonore ou visuelle perceptible par le conducteur lorsque le contrôleur embarqué (3) détecte une diminution de la tension de la batterie alors que le véhicule roule.

7. Système de traitement de données selon la revendication 6, **caractérisé en ce que** le contrôleur embarqué (3) déduit que le véhicule est arrêté par détection d'une absence de variation de la pression de tout ou partie de chacun des quatre pneus, et **en ce qu'**il comprend des moyens de déclenchement d'une alarme sonore ou visuelle perceptible par le conducteur lorsque le contrôleur embarqué (3) détecte une diminution de la tension de la batterie en dessous d'un certain seuil alors que le véhicule est à l'arrêt.

8. Système de traitement de données selon l'une quelconque des revendications précédentes, **caractérisé en ce que** l'appareil portable dispose d'une caméra destinée à prendre des images des capteurs de pression TPMS et de la batterie afin d'en extraire un ensemble de premières données dont un identifiant dit « premier », l'appareil disposant en outre d'un moyen d'émission d'un signal de réveil vers lesdits capteurs afin de recevoir par radio un ensemble de secondes données dont un identifiant dit « second », l'égalité entre le premier et le second identifiants déclenchant la mémorisation d'une association entre cet identifiant et une information représentative de la position et du type de capteur placé devant l'outil.

9. Système de traitement de données selon l'une quelconque des revendications 6 et 7, **caractérisé en ce que** le contrôleur embarqué transmet lors d'intervalles de temps déterminés les données émises par au moins un capteur de façon à afficher une information représentative de ces données sur le tableau de bord du véhicule.

10. Système de traitement de données selon l'une quelconque des revendications précédentes, **caractérisé en ce que** l'appareil portable de test (8) reçoit d'au moins un capteur (2,7) une information caractérisant le protocole de communication dudit capteur, et transmet au contrôleur embarqué un ensemble de données permettant au contrôleur d'acquérir les données émis par ce capteur.

11. Procédé de test et de contrôle de sécurité d'un véhicule mis en œuvre dans un système de traitement de données selon l'une quelconque des revendications 6 à 10, **caractérisé en ce qu'**il comprend tout ou partie des étapes suivantes :
- mise en communication de l'appareil portable (8) avec le contrôleur embarqué (3) ;
- émission par l'appareil portable vers le contrôleur embarqué (3) d'une requête pour obtenir la transmission d'une première série de données issues tant des capteurs TPMS que du capteur de batterie ;
- en fonction d'un traitement effectué dans l'appareil portable sur ladite première série de données, l'appareil portable communique éventuellement une seconde fois avec le contrôleur embarqué (3) pour obtenir la transmission d'une deuxième série de données issues des capteurs TPMS et/ou du capteur de batterie.

12. Procédé de test et de contrôle de sécurité d'un véhicule mis en œuvre dans un système de traitement de données selon l'une quelconque des revendications 6 à 10, **caractérisé en ce qu'**il comprend tout ou partie des étapes suivantes :
- mise en communication de l'appareil portable de test (8) avec le contrôleur embarqué (3) ;
- vérification que le moteur du véhicule est à l'arrêt ou en marche suivant la procédure de test à réaliser ;
- simulation du roulement du véhicule roule sur un banc de test approprié ;
- pilotage par l'appareil portable de test (8) du contrôleur embarqué (3) pour exécuter au moins une phase de test prédéterminée selon un protocole de test du bon fonctionnement du système de traitement de données selon l'une quelconque des revendications 1 à 6 ;
- récupération par l'appareil portable en provenance du contrôleur embarqué (3) d'au moins une première série de données issues tant des capteurs TPMS que du capteur de batterie telles que générées pendant ladite phase de test prédéterminée.

13. Procédé de test et de contrôle de sécurité d'un véhicule mis en œuvre dans un système de traitement de données selon l'une quelconque des revendications 1 à 10, et appliqué à un véhicule (1) dans lequel un système de charge de batterie est connecté et déconnecté en fonction de premières données relatives à l'état de charge de ladite batterie, **caractérisé en ce que** le système de charge de batterie est également piloté à partir de secondes données fournies par le contrôleur embarqué (3), et relatives aux données de grandeurs physiques mesurées sur chaque pneu du véhicule.

14. Appareil portable de test utilisable dans un système de traitement de données selon l'une quelconque des revendications 1 à 10 et/ou mettant en œuvre un procédé de contrôle selon l'une quelconque des revendications 11 à 13.

15. Contrôleur embarqué utilisable dans un système de traitement de données selon l'une quelconque des revendications 1 à 10 et/ou mettant en œuvre un procédé de contrôle selon l'une quelconque des revendications 11 à 13.

## Patentansprüche

1. System zur Verarbeitung von Daten, die von Drucksensoren (2) der auf einem Fahrzeug (1) montierten Reifen ausgesendet werden, von der Art mit einem Monitoring-Tool, das Daten physikalischer Größen empfängt, die von TPMS-Sensoren an jedem Reifen des Fahrzeugs gemessen werden,
**dadurch gekennzeichnet, dass** das Monitoring-Tool ebenfalls Daten über die Batterie (6) des Fahrzeugs empfängt,
wobei das Monitoring-Tool ferner Korrelationsmittel von Daten im Datensatz aufweist, der durch die von den Drucksensoren empfangenen und durch die auf die Batterie bezogenen Daten sowie durch Referenzwerte gebildet ist, wobei die Korrelationsmittel Mittel zur Steuerung und/oder zur Aktualisierung von Alarm- und/oder Monitoringfunktionen des Monitoring-Tools steuern.

2. Datenverarbeitungssystem nach Anspruch 1, **dadurch gekennzeichnet, dass** das Monitoring-Tool zu der Gruppe gehört, die ein tragbares Testgerät (8) mit einer Benutzerschnittstelle und einen in dem Fahrzeug befindlichen Onboard-Controller (3) umfasst.

3. Datenverarbeitungssystem nach einem beliebigen der Ansprüche 1 und 2, **dadurch gekennzeichnet, dass** die auf die Batterie (6) des Fahrzeugs bezogenen Daten durch Daten physikalischer Größen bezüglich der Batterie gebildet sind, die von einem Testsensor (7) der Batterie gemessen werden.

4. Datenverarbeitungssystem nach einem beliebigen der Ansprüche 1 bis 3, **dadurch gekennzeichnet, dass** die Mittel zur Steuerung und/oder Aktualisierung von Monitoringfunktionen des Monitoring-Tools zu der Gruppe gehören, die umfasst:
- Mittel, die es ermöglichen, ein Fahrzeug besser zu identifizieren;
- Mittel, die es ermöglichen, Protokolle zur Abfrage der Sensoren und/oder der Referenzwerte herunterzuladen und/oder zu aktualisieren;
- Mittel, um die Bedienperson besser zu unterstützen, indem ihr Empfehlungen und/oder Alarme adressiert werden.

5. Datenverarbeitungssystem nach einem beliebigen der Ansprüche 1 bis 4, **dadurch gekennzeichnet, dass** das Monitoring-Tool ein tragbares Testgerät (8) mit einer Benutzerschnittstelle ist, das dazu bestimmt ist, mit einem in dem Fahrzeug befindlichen Onboard-Controller (3) zusammenzuwirken, der periodisch Daten physikalischer Größen empfängt, die von TPMS-Sensoren an jedem Reifen des Fahrzeugs gemessen werden,
und dass der Controller (3) Daten physikalischer Größen speichert, die einerseits an jedem Reifen und andererseits an der Batterie des Fahrzeugs gemessen werden, und diese in einem vorbestimmten Format in Form einer Historie an das tragbare Testgerät überträgt.

6. Datenverarbeitungssystem nach Anspruch 1, bei dem das Monitoring-Tool ein in dem Fahrzeug befindlicher Onboard-Controller (3) ist, der periodisch Daten physikalischer Größen empfängt, die von TPMS-Sensoren an jedem Reifen des Fahrzeugs gemessen werden,
und bei dem das Fahrzeug (1) einen Verbrennungsmotor und einen Wechselstromgenerator aufweist, der die Batterie auflädt, während das Fahrzeug fährt,
**dadurch gekennzeichnet, dass** der Onboard-Controller (3) Mittel aufweist, um durch Analyse der relativen Veränderungen des Drucks aller oder eines Teils der vier Reifen zu folgern, dass das Fahrzeug fährt, und dass er Mittel zum Auslösen eines von dem Fahrer wahrnehmbaren akustischen oder optischen Alarms umfasst, wenn der Onboard-Controller (3) eine Verringerung der Spannung der Batterie erkennt, während das Fahrzeug fährt.

7. Datenverarbeitungssystem nach Anspruch 6, **dadurch gekennzeichnet, dass** der Onboard-Controller (3) durch Erkennen einer ausbleibenden Veränderung des Drucks aller oder eines Teils aller vier Reifen folgert, dass das Fahrzeug steht, und dass er Mittel zum Auslösen eines von dem Fahrer wahrnehmbaren akustischen oder optischen Alarms umfasst, wenn der Onboard-Controller (3) einen Abfall der Spannung der Batterie unter einen bestimmten Schwellenwert erkennt, während das Fahrzeug steht.

8. Datenverarbeitungssystem nach einem beliebigen der vorhergehenden Ansprüche, **dadurch gekennzeichnet, dass** das tragbare Gerät über eine Kamera verfügt, die dazu bestimmt ist, Bilder der TPMS-Drucksensoren und der Batterie aufzunehmen, um daraus einen Satz erster Daten zu extrahieren, darunter eine sogenannte "erste" Kennung, wobei das Gerät ferner über ein Mittel zum Senden eines Wecksignals an die Sensoren verfügt, um per Funk einen Satz zweiter Daten, darunter eine sogenannte "zweite" Kennung, zu erhalten, wobei die Gleichheit zwischen der ersten und der zweiten Kennung das Speichern einer Zuordnung zwischen dieser Kennung und einer Information auslöst, die für die Position und den Typ des vor dem Tool angeordneten Sensors repräsentativ ist.

9. Datenverarbeitungssystem nach einem beliebigen der Ansprüche 6 und 7, **dadurch gekennzeichnet, dass** der Onboard-Controller die von mindestens einem Sensor gesendeten Daten in bestimmten Zeitabständen überträgt, so dass an dem Armaturenbrett des Fahrzeugs eine für diese Daten repräsentative Information angezeigt wird.

10. Datenverarbeitungssystem nach einem beliebigen der vorhergehenden Ansprüche, **dadurch gekennzeichnet, dass** das tragbare Testgerät (8) von mindestens einem Sensor (2,7) eine das Kommunikationsprotokoll des Sensors kennzeichnende Information empfängt und dem Onboard-Controller einen Datensatz übermittelt, der es dem Controller ermöglicht, die von diesem Sensor gesendeten Daten zu erfassen.

11. Verfahren zum Testen und Prüfen der Sicherheit eines Fahrzeugs, das in einem Datenverarbeitungssystem nach einem beliebigen der Ansprüche 6 bis 10 implementiert ist, **dadurch gekennzeichnet, dass** es alle oder einen Teil der folgenden Schritte umfasst:
- Inverbindungsetzen des tragbaren Geräts (8) mit dem Onboard-Controller (3);
- Senden einer Anfrage von dem tragbaren Gerät an den Onboard-Controller (3), um die Übertragung einer ersten Reihe von Daten zu erreichen, die sowohl von den TPMS-Sensoren als auch von dem Batteriesensor stammen;
- in Abhängigkeit von einer Verarbeitung der ersten Datenreihe in dem tragbaren Gerät kommuniziert das tragbare Gerät eventuell ein zweites Mal mit dem On-board-Controller (3), um die Übertragung einer zweiten Reihe von Daten zu erreichen, die von den TPMS-Sensoren und/oder von dem Batteriesensor stammen.

12. Verfahren zum Testen und Prüfen der Sicherheit eines Fahrzeugs, das in einem Datenverarbeitungssystem nach einem beliebigen der Ansprüche 6 bis 10 implementiert ist, **dadurch gekennzeichnet, dass** es alle oder einen Teil der folgenden Schritte umfasst:
- Inverbindungsetzen des tragbaren Testgeräts (8) mit dem Onboard-Controller (3);
- Überprüfen, je nach dem durchzuführenden Testverfahren, ob der Motor des Fahrzeugs steht oder läuft;
- Simulieren des Rollens des Fahrzeugs auf einem geeigneten Prüfstand;
- Steuerung des Onboard-Controllers (3) durch das tragbare Testgerät (8), um mindestens eine vorbestimmte Testphase gemäß einem Protokoll für den Test der korrekten Funktionsweise des Datenverarbeitungssystems nach einem beliebigen der Ansprüche 1 bis 6 durchzuführen;
- Rückgewinnung durch das tragbare Gerät aus dem Onboard-Controller (3) von mindestens einer ersten Reihe von sowohl von den TPMS-Sensoren als auch von dem Batteriesensor stammenden Daten, wie sie während der vorbestimmten Testphase erzeugt wurden.

13. Verfahren zum Testen und Prüfen der Sicherheit eines Fahrzeugs, das in einem Datenverarbeitungssystem nach einem beliebigen der Ansprüche 1 bis 10 implementiert ist und das auf ein Fahrzeug (1) angewendet wird, in dem ein Batterieladesystem in Abhängigkeit von ersten Daten über den Ladezustand der Batterie angeschlossen und getrennt wird, **dadurch gekennzeichnet, dass** das Batterieladesystem ebenfalls anhand von zweiten, von dem Onboard-Controller (3) bereitgestellten und auf Daten physikalischer Größen, die am jeweiligen Reifen des Fahrzeugs gemessen werden, bezogenen Daten gesteuert wird.

14. Tragbares Testgerät, das in einem Datenverarbeitungssystem nach einem beliebigen der Ansprüche 1 bis 10 und/oder das ein Kontrollverfahren nach einem beliebigen der Ansprüche 11 bis 13 umsetzt, einsetzbar ist.

15. Onboard-Controller, der in einem Datenverarbeitungssystem nach einem beliebigen der Ansprüche 1 bis 10 und/oder das ein Kontrollverfahren nach einem beliebigen der Ansprüche 11 bis 13 umsetzt, einsetzbar ist.

## Claims

1. A system for processing data transmitted by pressure sensors (2) of the tires mounted on a vehicle (1), of the type including a monitoring tool receiving data on physical quantities measured by TPMS sensors on each tire of the vehicle,
**characterised in that** said monitoring tool also receives data relating to the battery (6) of the vehicle,
said monitoring tool further including means for correlating data within the set formed by said data received from the pressure sensors and those relating to the battery as well as reference values, said correlation means driving means for controlling and/or updating warning and/or monitoring functions of said monitoring tool.

2. The data processing system according to claim 1, **characterised in that** said monitoring tool belongs to the group comprising a portable test apparatus (8) provided with a user interface, and an on-board controller (3) on said vehicle.

3. The data processing system according to any one of claims 1 and 2, **characterised in that** said data relating to the battery (6) of the vehicle consist of data on physical quantities relating to the battery, measured by a test sensor (7) of said battery.

4. The data processing system according to any one of claims 1 to 3, **characterised in that** said means for controlling and/or updating monitoring functions of said monitoring tool belong to the group comprising:
- means allowing to better identify a vehicle;
- means allowing to download and/or update protocols for querying the sensors and/or reference values;
- means for better assisting the operator, by addressing recommendations and/or warnings to him/her.

5. The data processing system according to any one of claims 1 to 4, **characterised in that** said monitoring tool is a portable apparatus (8) provided with a user interface, intended to cooperate with an on-board controller (3) on said vehicle periodically receiving data on physical quantities measured by TPMS sensors on each tire of the vehicle,
and **in that** the controller (3) memorises data on physical quantities measured on each tire on the one hand and on the battery of the vehicle on the other hand, and transmits them according to a predetermined format in the form of a history to the portable test apparatus.

6. The data processing system according to claim 1, wherein said monitoring tool is an on-board controller (3) on said vehicle periodically receiving data on physical quantities measured by TPMS sensors on each tire of the vehicle,
and wherein the vehicle (1) has a heat engine and an alternator recharging the battery when the vehicle moves,
**characterised in that** the on-board controller (3) has means for deducing that the vehicle is moving by analysis of the relative variations of the pressure of all or part of the four tires, and **in that** it comprises means for triggering an audible or visual alarm perceptible by the driver when the on-board controller (3) detects a decrease in the voltage of the battery while the vehicle is moving.

7. The data processing system according to claim 6, **characterised in that** the on-board controller (3) deduces that the vehicle is at stop by detection of an absence of variation of the pressure of all or part of each of the four tires, and **in that** it comprises means for triggering an audible or visual alarm perceptible by the driver when the on-board controller (3) detects a decrease in the voltage of the battery below a determined threshold while the vehicle is at stop.

8. The data processing system according to any one of the preceding claims, **characterised in that** the portable apparatus is provided with a camera intended to capture images from the TPMS pressure sensors and from the battery in order to extract a set of first data including a so-called "first" identifier, the apparatus being further provided with a means for transmitting a wakeup signal to said sensors in order to receive by radio a set of second data including a so-called "second" identifier, the equality between the first and second identifiers triggering the memorisation of an association between this identifier and information representative of the position and of the type of sensor placed in front of the tool.

9. The data processing system according to any one of claims 6 and 7, **characterised in that** the on-board controller transmits during determined time intervals the data transmitted by at least one sensor so as to display information representative of these data on the dashboard of the vehicle.

10. The data processing system according to any one of the preceding claims, **characterised in that** the portable test apparatus (8) receives from at least one sensor (2, 7) information characterising the communication protocol of said sensor, and transmits to the on-board controller a data set enabling the controller to acquire the data transmitted by this sensor.

11. A method for testing and controlling safety of a vehicle implemented in a data processing system according to any one of claims 6 to 10, **characterised in that** it comprises all or part of the following steps:
- setting the portable apparatus (8) in communication with the on-board controller (3);
- the portable apparatus transmitting to the on-board controller (3) a query to obtain the transmission of a first series of data originating from both the TPMS sensors and the battery sensor;
- depending on the treatment performed in the portable apparatus on said first series of data, the portable apparatus possibly communicates a second time with the on-board controller (3) to obtain the transmission of a second series of data originating from the TPMS sensors and/or from the battery sensor.

12. A method for testing and controlling safety of a vehicle implemented in a data processing system according to any one of claims 6 to 10, **characterised in that** it comprises all or part of the following steps:
- setting the portable test apparatus (8) in communication with the on-board controller (3);
- checking that the engine of the vehicle is at stop or running depending on the test procedure to be carried out;
- simulating the movement of the vehicle on an appropriate test bench;
- the portable test apparatus (8) driving the on-board controller (3) to execute at least one predetermined test phase according to a protocol for testing the proper operation of the data processing system according to any one of claims 1 to 6;
- the portable apparatus recovering from the on-board controller (3) at least one first series of data originating from both the TPMS sensors and the battery sensor as generated during said predetermined test phase.

13. A method for testing and controlling safety of a vehicle implemented in a data processing system according to any one of claims 1 to 10, and applied to a vehicle (1) wherein a battery charging system is connected and disconnected according to first data relating to the state-of-charge of said battery, **characterised in that** the battery charging system is also driven from second data supplied by the on-board controller (3), and relating to the data on physical quantities measured on each tire of the vehicle.

14. A portable test apparatus that can be used in a data processing system according to any one of claims 1 to 10 and/or implementing a control method according to any one of claims 11 to 13.

15. An on-board controller that can be used in a data processing system according to any one of claims 1 to 10 and/or implementing a controlling method according to any one of claims 11 to 13.
